# EUROPEAN PATENT APPLICATION

(11) **EP 1 347 450 A2**
(43) Date of publication of application: **24.09.2003**
(21) Application number: 03003956.4
(22) Date of filing: 21.02.2003
(51) Int. Cl.: G11B 7/26

(54) **Information recording method using electron beam, information recording apparatus, and recording medium**

(30) Priority: 22.02.2002 JP 2002045795; 27.02.2002 JP 2002050766
(71) Applicant: Pioneer Corporation, Meguro-ku, Tokyo (JP)
(72) Inventor: Kumasaka, Osamu, Tokyo (JP); Kobayashi, Masaki, Tokyo (JP); Sone, Masami, Tokyo (JP); Kamimura, Kenji, Tokyo (JP); Kaneda, Hiroki, Tokyo (JP); Kuriyama, Kazumi, Tokyo (JP)
(74) Representative: Betten & Resch

(57) **Abstract**

Information recording method and apparatus for manufacturing a master medium to manufacture a recording medium which can obtain a good read signal waveform even from a recording pit of a short pit length for manufacturing the master disc which can precisely form a pit of an optimum shape, and the recording medium are provided. There is also provided an information recording method of irradiating a resist layer formed on a substrate with an electron beam to form a latent image of a recording pit train along a track, wherein, an irradiation process is performed with the electron beam driven to cause a micro-reciprocal motion in a direction crossing the track direction while an irradiation position of the electron beam is moved in the track direction, and an amplitude of the micro-reciprocal motion is adjusted in accordance with a pit length of the recording pit.

## Description

### BACKGROUND OF THE INVENTION

### Field of the Invention

The invention relates to an information recording apparatus using an electron beam such as electron beam or laser beam. More particularly, the invention relates to an information recording apparatus and an information recording method which are used for a manufacturing apparatus for manufacturing a master disk of a recording medium having a recording pit train, such as read only optical disc, magnetooptical disc, phase change type disc, or magnetic disc.

The invention also relates to a recording medium such as optical disc or magnetic disc which is duplicated from the master disc in accordance with the information recording method.

### Description of the Related Art

As optical recording media on which data can be recorded, optical discs such as write once type DVD-R (Digital Versatile Disc-Recordable) and rewritable type DVD-RW (Digital Versatile Disc-ReWritable) are known. On those optical discs, an information signal which includes rotation control information such as a wobbling signal which is used for rotation control of the optical disc, address information necessary for position search or the like upon recording of data, and the like is usually recorded on tracks (groove tracks or land tracks) as concave or convex portions which have previously been formed upon manufacturing of a master disc. When manufacturing those optical discs, first, predetermined concave/convex patterns corresponding to a recording signal are recorded along the track on the master disc, and disc stampers are formed from the recorded master disc. A synthetic resin or the like is processed by a hot-press work or injection molded by using the disc stamper, a recording surface onto which the concave/convex patterns have been transferred from the master disc is subjected to a metal evaporation depositing process, and a transparent substrate or the like is formed thereon, to obtain an optical disc which will be supplied to the market.

The recording of the concave/convex patterns onto the master disc is executed by an information recording apparatus. By appropriately moving a head which projects a laser beam in the radial direction while the recording surface of the master disc rotates, a spot of the laser beam is positioned so as to draw a spiral or concentric locus (track) with an almost constant spacing. Along the locus, information pits or grooves are formed on the master disc by turning on/off the laser beam in accordance with the speed of rotation of the master disc and information contents of the recording master disc.

In recent years, a substantial progress is achieved in research and development of a recording medium whose recording density is higher than that of a DVD, and realization of an ultrafine track pitch is sought. For example, as compared with a track pitch of 0.74µ which is sufficient for the DVD using a red laser, a track pitch of 0.3 µ or less is required for the high density DVD using a blue laser.

In the case of a track cutting step, that is, a mastering step of the master disc using the conventional laser beam, however, a spot diameter of the laser beam for recording cannot be reduced to a sufficiently small diameter due to restrictions associated with the wavelength of the laser beam and a numerical aperture NA of an objective lens, so that recording resolution is limited. Therefore, the development of a cutting technique of a master disc is being attempted, in which electron beam exposure is used so that a spot diameter becomes smaller than that of the laser beam thereby allowing the improvement of the recording resolution.

With the master disc cutting scheme using the electron beam exposure, a resist layer for the electron beam is formed on the master disc and the resist layer is irradiated with the electron beam in accordance with information data which has been subjected to a recording-modulation process. In this scheme, a first step is to form a latent image having a shape corresponding to a recording pit at a position irradiated with the electron beam. Subsequently, a mask pattern is formed by deleting from the resist layer only the portion where the latent image has been formed. By using the mask pattern, a stamper on which a recording pit train in a convex or concave shape corresponding to the recording pits has been formed is formed, thereby optical discs are manufactured by using the stamper.

Japanese patent application No. 11-283283 discloses a master disc manufacturing method in which the electron beam is intensity-modulated in a pulse-like fashion when forming a latent image by an electron beam exposure to a resist layer, thereby forming a latent image of predetermined recording pits.

As for the shape of the latent image formed by the recording process using the electron beam exposure, however if the length of a recording pit to be formed is short, its pit width (mark width) will be narrower than that of the long recording pit. This, consequently, leads to a problem that a good read signal waveform cannot be obtained from the optical disc manufactured by using the stamper formed by the electron beam exposure.

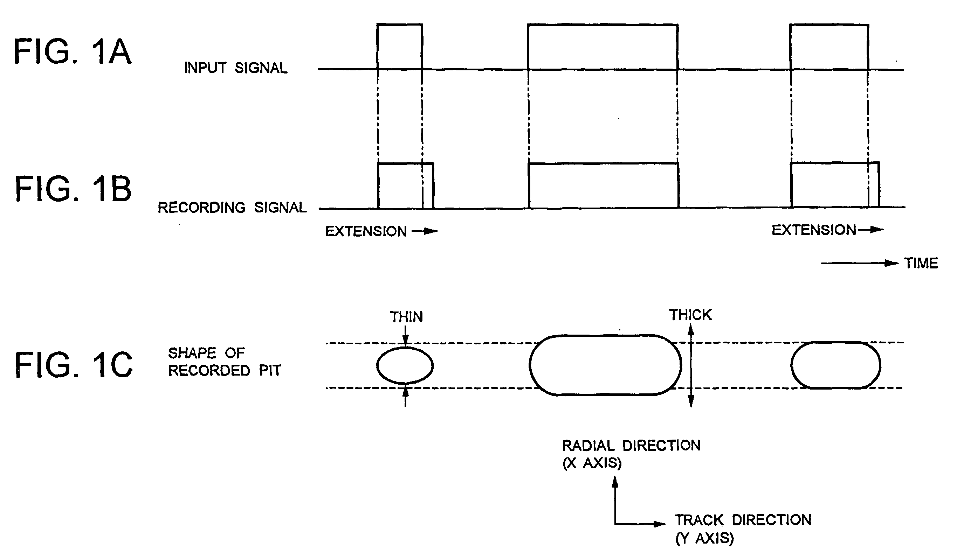

As shown in Figs. 1A to 1C, in order to assure a reproducing quality, a method has been used in which the time of exposure is prolonged as the bit length of a supplied recording signal becomes shorter, so that a pit area which is thus obtained is increased.

However, if formation of finer recording pits is pursued in order to realize higher recording density, there arises a problem that, the optimum pit shape cannot be obtained by merely adjusting the exposing time, so that a good reproduction signal cannot be expected.

### OBJECTS AND SUMMARY OF THE INVENTION

The invention has been.made to solve the foregoing problems and it is an object of the invention to provide information recording method and apparatus for manufacturing a master disc which can accurately form pits of an optimum shape and to provide a recording medium.

According to a first aspect of the invention, there is provided an information recording method in which a resist layer formed on a substrate is irradiated with an electron beam, to form latent image of a recording pit train along a track, comprising the steps of: performing an irradiation process with the electron beam driven to cause a micro-reciprocal motion in a direction crossing the track direction while an irradiation position of the electron beam is moved in a direction of the track; and adjusting an amplitude of the micro-reciprocal motion in accordance with a pit length of a recording pit to be formed.

According to a second aspect of the invention, there is provided an information recording apparatus which has a rotation driving unit for supporting and rotating a master disc on which a resist layer has been formed, and an electron beam emitting unit for irradiating the master disc with an electron beam so that the electron beam can be freely deflected, thereby the information recording apparatus forming a latent image of a recording pit train along a track forming direction of the master disc being rotated, comprising: an emission control unit for supplying an instruction to modulate an intensity of the electron beam in accordance with data to form recording pits to the electron beam emitting unit; and a deflection control unit for supplying an instruction to cause, in an irradiating process, a micro-reciprocal motion of the intensity-modulated electron beam in a direction crossing the track forming direction and to adjust an amplitude of the micro-reciprocal motion of the electron beam in accordance with a pit length of a recording pit to be formed to the electron beam emitting unit.

According to a third aspect of the invention, there is provided an information recording medium including a substrate duplicated by using a master disc in which a recording pit train has been formed on a resist layer, wherein the medium is obtained by a duplication through execution of: an information recording step of performing an irradiation process with an electron beam driven to cause a micro-reciprocal movement, the electron beam having been intensity-modulated in accordance with data to form recording pits in a direction crossing the track forming direction of rotation of the master disc while the master disc on which the resist layer has been formed is supported to rotate, and adjusting an amplitude of the micro-reciprocal motion in accordance with a pit length of a pit to be recorded, thereby forming a latent image of the recording pit train; a developing step of developing the latent image of the recording pit train formed by the information recording step and forming a developed recording pit train in the resist layer; and a transferring step of manufacturing a stamper on which the recording pit train is formed by transferring the recording pit train formed and developed by the developing step.

Other objects of the invention are to provide an information recording method and an information recording apparatus for manufacturing a master disc for manufacturing a recording medium with which a good read signal waveform can be obtained even from a recording pit of a short pit length, and to provide the recording medium.

According to a fourth aspect of the invention, there is provided an information recording method of irradiating an exposing beam onto a resist layer formed on a substrate in accordance with a pulse signal corresponding to a recording pit train, thereby recording a latent image corresponding to the recording pit along a track onto the resist layer, comprising: an irradiating period adjusting step of adjusting an irradiating period of the exposing beam in accordance with a pulse width of the pulse signal; and a deflecting step of deflecting the exposing beam in the direction along the track in response to the pulse signal.

According to a fifth aspect of the invention, there is provided an information recording apparatus for irradiating an exposing beam onto a surface of a resist layer formed on a master disc, thereby forming a latent image corresponding to the recording pits onto the resist layer along a track, comprising: a rotation driving unit for rotating the master disc; an exposing beam emitting unit for irradiating the exposing beam onto the surface of the resist layer for a period of time obtained by adding an offset period which is longer as a pulse width of a pulse signal corresponding to the recording pit train becomes shorter to the pulse width; and a beam deflecting unit for deflecting the exposing beam in the direction along the track by a deflection amount according to the pulse width of the pulse signal.

According to a sixth aspect of the invention, there is provided a recording medium having a substrate duplicated based on a master disc on which a predetermined recording pit train has been formed along a track and a recording layer formed on the substrate, wherein the recording medium is duplicated by executing: an information recording step of rotating the master disc on which a resist layer has been formed, and irradiating an exposing beam onto the resist layer while deflecting the exposing beam in the direction along the track by a deflection amount according to a pulse width of a pulse signal corresponding to the recording pit train, thereby forming a latent image corresponding to the recording pit train onto the resist layer; a developing step of developing the latent image formed on the resist layer and forming a recording mark onto the resist layer; and a transfer step of transferring the resist layer on which the recording mark has been formed, thereby producing a stamper on which the predetermined recording pit train has been formed.

### BRIEF DESCRIPTION OF THE DRAWINGS

Figs. 1A to 1C are diagrams for explaining the relationship between the length and width of a pit;
Fig. 2 is a diagram schematically showing the construction of a electron beam recorder as a whole;
Fig. 3 is a block diagram showing a more detailed construction of a beam deflecting circuit of the electron beam recorder shown in Fig. 2 in the first embodiment;
Fig. 4 is a diagram showing a set example of a table of deflecting conditions for micro-reciprocal motion in the first and second embodiments;
Fig. 5 is an explanatory diagram for explaining a state of a locus of an electron beam which is obtained by the electron beam recorder in the first embodiment;
Figs. 6A to 6C are diagrams showing the shapes of recording pits which are obtained in correspondence to a recording modulation signal and a micro-reciprocal motion deflection signal in the first embodiment;
Fig. 7 is a block diagram showing a more detailed construction of the beam deflecting unit of the electron beam recorder shown in Fig. 2 in the second embodiment;
Figs. 8A to 8C are diagrams showing the shapes of recording pits which are obtained in correspondence to a recording modulation signal and a micro-reciprocal motion deflection signal in the second embodiment;
Fig. 9 is a schematic block diagram showing another example of an electron beam recorder according to the invention;
Fig. 10 is a diagram showing a track direction Y and a disc radial direction X on the surface of a master disc 15;
Fig. 11 is a diagram showing an example of latent images SZ formed on a resist layer of the master disc 15;
Fig. 12 is a diagram showing an example of a blanking signal BL and a track direction deflection signal Y(t) which is formed on the basis of a recording modulation signal MS;
Figs. 13A and 13B are schematic cross sectional views showing a state of recording onto the resist layer of the master disc 15;
Fig. 14 is a diagram schematically showing a manufacturing flow which is executed until a stamper is produced; and
Fig. 15 is a diagram showing another example of the track direction deflection signal Y(t).

### DETAILED DESCRIPTION OF THE PREFERRED EMBODIMENTS

An embodiment of the invention will be described in detail with reference to the drawings.

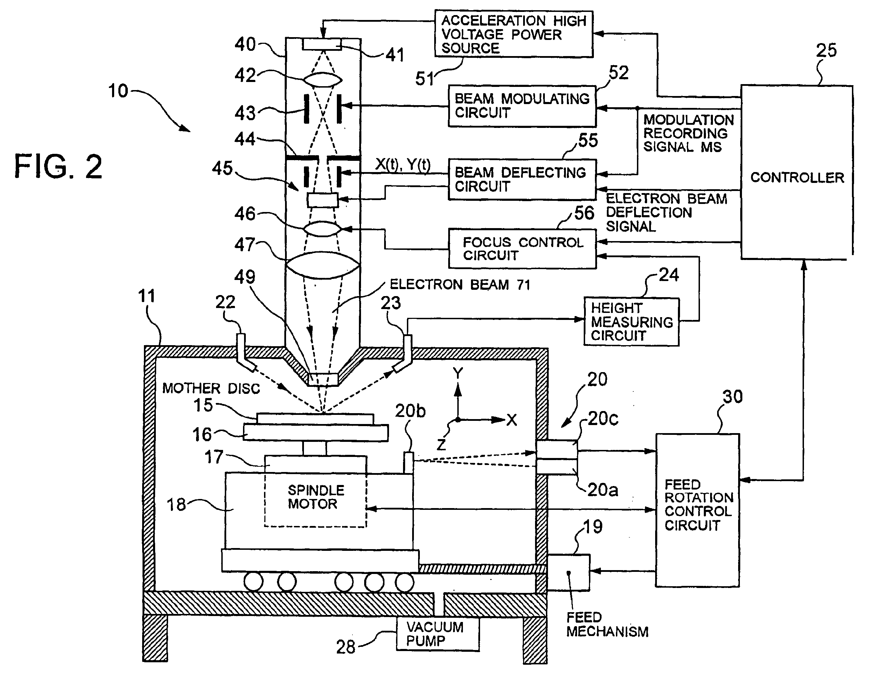

Fig. 2 is a diagram schematically showing an electron beam recorder 10 as an information recording apparatus according to the embodiment of the invention.

Since an electron beam has a characteristic such that it diminishes significantly in an atmosphere ambience, an electron beam exposure is executed in a vacuum ambience. The electron beam recorder 10, therefore, has a vacuum chamber 11 for enclosing a driving mechanism for rotating and translation driving a master disc 15 and the like so that they operate in a vacuum ambient. An electron beam column portion 40 for emitting an electron beam is provided in a vertical upper position of the principal plane of the master disc of the vacuum chamber 11. The electron beam recorder 10 also includes various modules, which will be explained later, for controlling the vacuum chamber 11 and the electron beam column portion 40. A vacuum pump 28 is connected to the vacuum chamber 11. By exhausting the air in the chamber by the vacuum pump 28, the inside of the chamber is set to a vacuum ambience of a predetermined pressure. The vacuum chamber 11 is attached onto a floor via a vibration isolating base (not shown) such as an air damper, so that transfer of a vibration from an outside is suppressed. For example, a silicon substrate is used as a master disc 15 and a resist layer for the electron beam is provided on its principal plane. The rotating master disc 15, therefore, is translation-driven in the horizontal direction and a latent image for micro concave/convex patterns such as prepits or grooves is spirally formed on the resist layer by a locus of an electron beam spot irradiated onto the master disc 15.

When considering the rotation driving portion and the relative movement driving portion shown in Fig. 2, in the vacuum chamber 11, the master disc 15 is put on a turntable 16 and rotated about a vertical axis at the center of the principal plane by the rotation of the turntable 16 by a spindle motor 17. The spindle motor 17 is mounted on a feed stage (hereinafter, simply referred to as a stage) 18 which can be moved rectilinearly by a slider. The spindle motor 17 comprises an antimagnetic motor having a vacuum correspondence air spindle structure or the like. The stage 18 is coupled with a feed mechanism 19 for screw feeding by a DC motor and can move the spindle motor 17 and the turntable 16 in a plane in the horizontal direction that is parallel with the principal plane of the master disc 15.

The spindle motor 17 and the feed mechanism 19 are connected to a feed rotation control circuit 30. The feed rotation control circuit 30 makes feedback servo control of the rotation on the basis of an output from an encoder of the spindle motor 17 and drives the feed mechanism 19 by using measured length data from a radial sensor 20 using a laser length measuring machine, thereby making feedback servo control of a speed of the stage 18. The feed rotation control circuit 30 controls a rotational speed of the spindle motor 17 and a feed distance of the feed mechanism 19 by a predetermined track pitch which is supplied from a controller 25 and the measured length data in a manner such that they are set to predetermined values, respectively. In the radial sensor 20, a laser beam source 20a and a photodetector 20c of the radial sensor 20 are provided on the inner wall on the side of the vacuum chamber 11. A reflecting mirror 20b for reflecting the laser beam emitted from the laser beam source is fixed to the stage 18.

The feed rotation control circuit 30 generates position data of the master disc to the controller 25. The controller 25 has a clock synchronizing circuit for generating sync clocks, synchronizes a signal indicative of the position data of the master disc from the feed rotation control circuit 30 with a recording modulation signal MS corresponding to the prepits, grooves, or the like to be recorded, and supplies the recording modulation signal MS to a beam modulating circuit 52, which will be explained later. The controller 25 and the feed rotation control circuit 30, consequently, allow the feed mechanism 19 to move the stage 18 together with the rotating master disc by a predetermined movement amount in which the stage advances by a predetermined number of track pitches every rotation of the master disc. The controller 25 generates an electron beam deflection signal to a beam deflecting circuit 55, which will be explained later, synchronously with the position data signal and the recording modulation signal MS.

When considering an electron beam emitting unit, a laser beam source 22 and a photodetector 23 for optically detecting a height of principal plane of the master disc 15 are provided on an inner wall of the vacuum chamber 11 on the side near the electron beam column portion 40. The laser beam source 22 irradiates the laser beam onto the surface of the master disc 15. The photodetector 23 supplies a photosensing signal obtained by photoelectrically converting the reflected light from the surface of the master disc 15 to a height measuring circuit 24. The height measuring circuit 24 measures the height of principal plane of the master disc 15 on the basis of the photosensing signal and supplies height data indicative of the height to a focus control circuit 56.

From an upper position, an electron gun 41, a convergent lens 42, a blanking electrode 43, an on/off control aperture 44, a beam deflecting electrode 45, a focus adjustment lens 46, and an objective lens 47 are arranged in this order in the electron beam column portion 40 on the vacuum chamber 11. An electron beam emitting port 49 provided at a tip of the electron beam column portion 40 is directed toward the master disc 15. When the electron beam emitted from the electron gun 41 passes through an opening portion of the aperture 44 for on/off control, the electron beam is converged by the objective lens 47, enters the principal plane of the master disc, and forms a micro electron beam spot thereon.

The electron gun 41 emits the electron beam accelerated by a high voltage of tens of KeV generated from an acceleration high voltage power source 51. The convergent lens 42 converges the emitted electron beam and guides it to the aperture 44. The blanking electrode 43 is controlled by the beam modulating circuit 52 and intensity modulates (on/off control) the electron beam on the basis of the recording modulation signal MS from the controller 25. That is, the beam modulating circuit 52 supplies a modulation signal to the blanking electrode 43 and applies a voltage to a gap of the blanking electrode 43, thereby largely deflecting the electron beam which passes. The passage of the electron beam to the aperture 44 is, consequently, blocked, thereby setting the electron beam to the OFF state. By allowing the electron beam to pass, it is set to the ON state.

The beam deflecting electrode 45 comprises biaxial electrodes which are arranged so as to face each other while passing through axes which cross perpendicularly. That is, the beam deflecting electrode is provided in a manner such that the passing electron beam can be independently deflected in two directions (X, Y) of an axis which is parallel with a diameter of the master disc on the surface that is parallel with the principal plane of the master disc and an axis which perpendicularly crosses that axis. The biaxial electrodes of the beam deflecting electrode 45 are controlled by a radial direction deflection signal X(t) and a deflection in a tangential direction, that is, a track direction deflection signal Y(t), which are generated from the beam deflecting circuit 55 and deflect the passing electron beam in the axial directions, respectively.

The beam deflecting circuit 55 forms the deflection signal in the track direction and the deflection signal in the radial direction on the basis of the electron beam deflection signal from the controller 25. The deflection signal in the track direction is supplied as a deflection signal Y(t) to the beam deflecting electrode 45. The deflection signal in the radial direction is synthesized with a deflection signal F(t) for micro-reciprocal motion and supplied as a deflection signal X(t) to the beam deflecting electrode 45. The beam deflecting circuit 55 further detects a residual error component on the basis of the measured length data from the radial sensor 20 and the rotational speed data from the encoder of the spindle motor 17 and corrects the deflection signals X(t) and Y(t), thereby enabling a position error of the electron beam spot on the principal plane of the master disc 15 to be also corrected.

The focus adjustment lens 46 is controlled by the focus control circuit 56. On the basis of a detection signal from the height measuring circuit 24, the focus control circuit 56 makes focus adjustment of the electron beam spot which is converged onto the principal plane of the master disc 15 by the objective lens 47. The acceleration high voltage power source 51 and the focus control circuit 56 also operate on the basis of control signals from the controller 25.

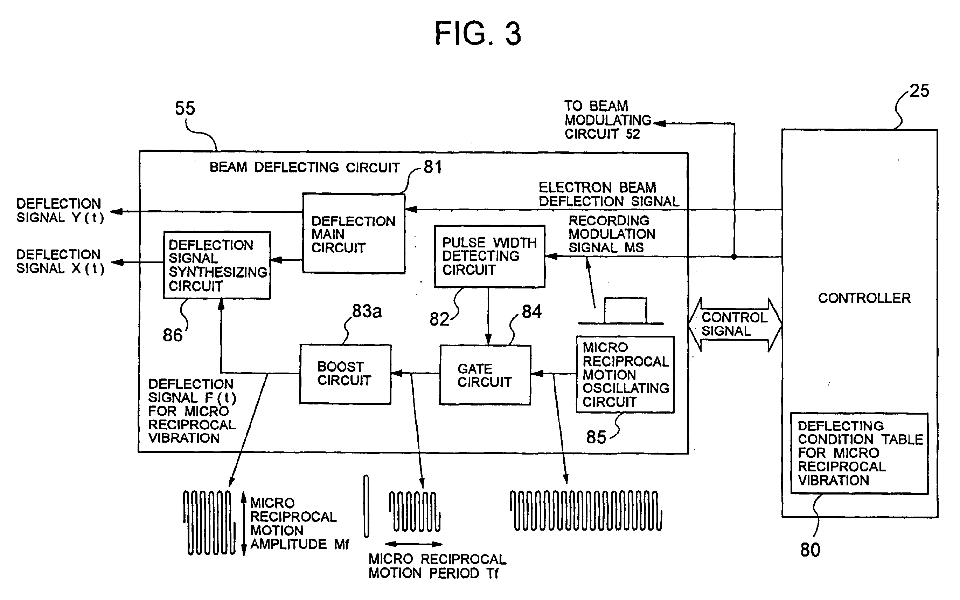

Fig. 3 shows a more detailed construction of the beam deflecting circuit 55 of the electron beam recorder shown in Fig. 2 in the first embodiment. The beam deflecting circuit 55 comprises: a deflection main circuit 81; a deflection signal synthesizing circuit 86; a pulse width detecting circuit 82; a boost circuit 83a; a gate circuit 84; and a micro-reciprocal motion oscillating circuit 85. The deflection main circuit 81 generates the deflection signals X(t) and Y(t) to be applied to the beam deflecting electrode 45 on the basis of the electron beam deflection signal from the controller 25 as mentioned above. The deflection signal synthesizing circuit 86 synthesizes a waveform of the deflection signal X(t) from the deflection main circuit 81 and a waveform of the deflection signal F(t) for micro-reciprocal motion, that is, additively superimposes the deflection signal F(t) for micro-reciprocal motion to the signal X(t). The pulse width detecting circuit 82 receives the recording modulation signal MS from the controller 25, detects its pulse width, that is, a width such as 1T, 2T, 3T, or 4T, and supplies its discrimination signal to the gate circuit 84. The micro-reciprocal motion oscillating circuit 85 continuously generates a micro-reciprocal motion signal of a frequency corresponding to a micro-reciprocal motion period Tf based on designation from the controller 25 and supplies it to the gate circuit 84. As a waveform of the micro-reciprocal motion signal, it is sufficient to use a waveform which can deflect the electron beam at a high speed and a triangular waveform such as a saw-tooth waveform or a sine waveform can be also used without limiting to a square waveform as shown in an example in Fig. 3.

On the basis of the discrimination signal of the pulse width which is supplied by the pulse width detecting circuit 82, the gate circuit 84 modifies the supplied micro-reciprocal motion signal to a burst signal which is matched with the pulse width or whose time width is slightly longer than the pulse width and supplies the modified signal to the boost circuit 83a. The boost circuit 83a amplifies the supplied burst signal to a magnitude of a micro-reciprocal motion amplitude Mf based on an instruction from the controller 25 and supplies it as a deflection signal F(t) for micro-reciprocal motion.

Since the irradiation of the electron beam is on/off controlled by the recording modulation signal MS, the beam deflection for micro-reciprocal motion can be also always set to the ON state. To rapidly deflect the amplitude of the micro-reciprocal motion in accordance with the length of recording pit, however, it is desirable to substantially synchronize the deflection signal F(t) for micro-reciprocal motion with the recording modulation signal MS like an embodiment.

The controller 25 controls the beam deflecting circuit 55 for the ordinary X-axis and Y-axis deflection of the electron beam as mentioned above and also makes control for the micro-reciprocal motion. For this purpose, the controller 25 has a deflecting condition table for the micro-reciprocal motion and controls the output of the deflection signal F(t) for micro-reciprocal motion of the beam deflecting circuit 55 on the basis of the deflecting conditions set in the table.

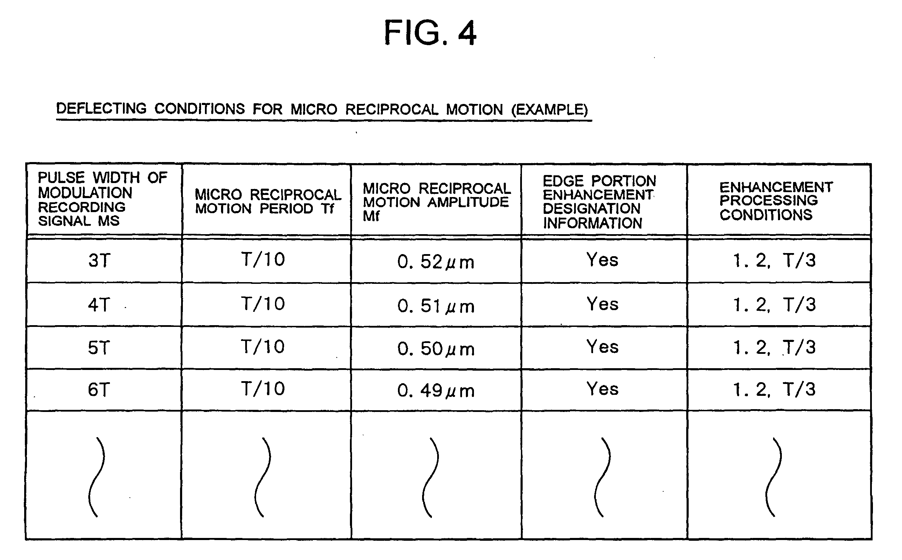

Fig. 4 shows an example of the setting of the deflecting condition table for the micro-reciprocal motion shown in Fig. 3. The micro-reciprocal motion period Tf, micro-reciprocal motion amplitude Mf, designation information showing whether an edge portion of a micro-reciprocal motion waveform is subjected to an emphasizing process, that is, an enhancement process or not, and conditions of the enhancement process are set every pulse width of the recording modulation signal MS. As conditions of the enhancement process, for example, there is shown a case where when the pulse width of the recording modulation signal is equal to "3T", the micro-reciprocal motion period is set to "T/10", the micro-reciprocal motion amplitude is set to "0.52 µm", the enhancement process of the edge portion is set to "YES", that is, "presence", the amplitude in the enhancement processing conditions is designated to "1.2" times, and further, the width of the enhancement portion is designated to "T/3". As for the amplitude Mf of the micro-reciprocal motion, there is shown a setting example of providing the amplitude which is sequentially reduced to 0.52 µm, 0.51 µm, 0.50 µm, and 0.49 µm as the value of the recording modulation signal MS increases to 3T, 4T, 5T, and 6T. It is necessary to preset the deflecting condition table for the micro-reciprocal motion. Since the creation of the pit shape depends on characteristics of the electron beam and characteristics of the resist layer of the master disc, it is necessary to predetermine the optimum conditions by experiments.

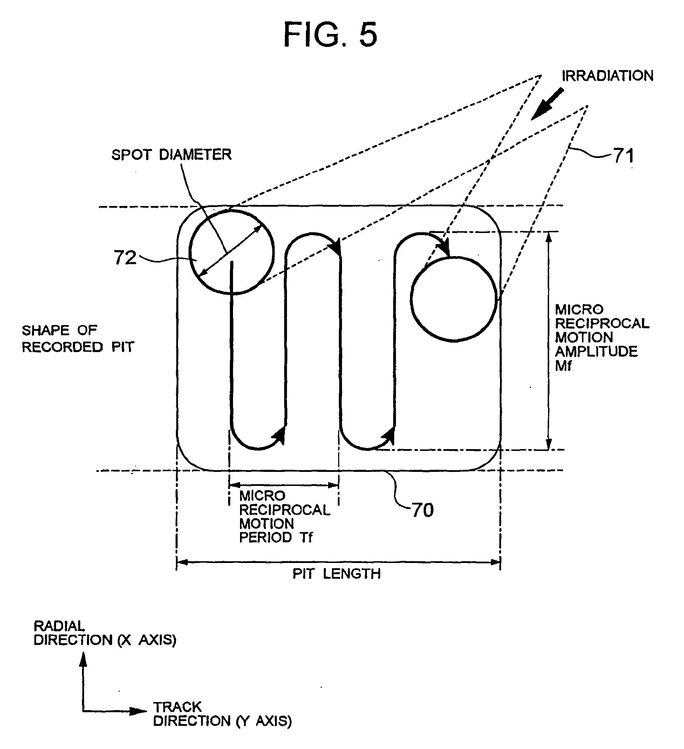

Fig. 5 is a diagram for explaining a locus of the electron beam which is obtained by the electron beam recorder of the first embodiment. In one pit 70, a beam spot 72 of an electron beam 71 reciprocates in a range from a start edge portion of the pit to an end edge portion. The period Tf and amplitude Mf of the micro-reciprocal motion are controlled by a deflecting voltage which is applied to the beam deflecting electrode 45. When the pit 70 is formed by the micro-reciprocal motion of the electron beam 71, it is desirable that a half value width of the beam intensity of the electron beam on the master disc, that is, a diameter of the spot 72 is sufficiently smaller than the shortest length and width of the pit 70. The micro-reciprocal motion period Tf is set to be sufficiently shorter than the shortest length of the pit 70.

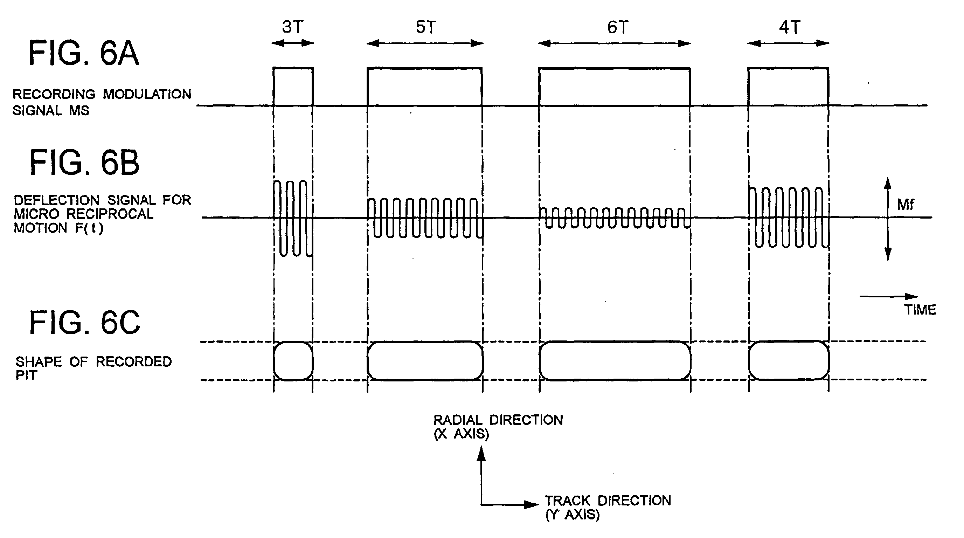

Figs. 6A to 6C show shapes of the recording pits which are obtained in correspondence to the recording modulation signal and the micro-reciprocal motion deflection signal in the first embodiment. As an example of the recording modulation signal MS, a pulse train whose pulse widths are equal to 3T, 4T, 5T, and 6T is shown. The micro-reciprocal motion deflection signal F(t) which is generated in accordance with it has a burst length matched with the pulse width of the recording modulation signal MS. When considering the amplitude Mf of the micro-reciprocal motion deflection signal F(t), the pit whose desired pit length is short is set to be larger than that in the case of the pit whose desired pit length is long. The shape of pit which is recorded has an almost constant width irrespective of the pulse width of the recording modulation signal MS and is formed so that a curvature R in a corner portion of.each of the front and rear edges of the pit is small.

According to the first embodiment, the electron beam which is used for irradiation is subjected to a micro-reciprocal motion having a vibration in a direction crossing the track direction and an amplitude according to the pit length, and a width of shape of the recording pit is fixed to a predetermined value. Owing to the information recording method and the information recording apparatus, an information recording medium which provides excellent reproducing characteristics and in which a jitter of a reproduction signal is improved can be obtained.

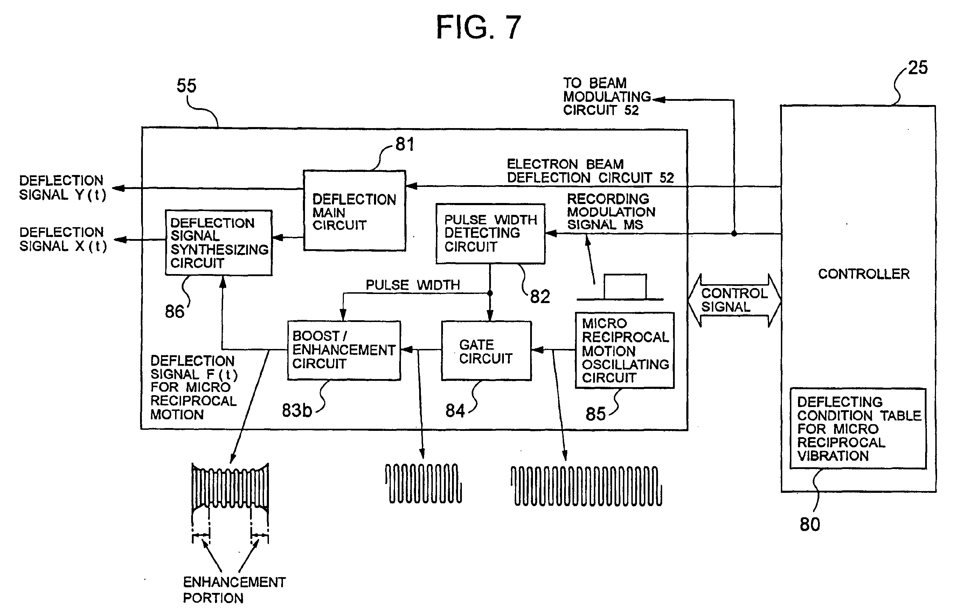

Fig. 7 is a diagram showing the second embodiment and shows a more detailed construction of the beam deflecting circuit 55 of the electron beam recorder 10 shown in Fig. 2. The beam deflecting circuit 55 comprises: the deflection main circuit 81; the deflection signal synthesizing circuit 86; the pulse width detecting circuit 82; a boost/enhancement circuit 83b; the gate circuit 84; and the micro-reciprocal motion oscillating circuit 85. The boost/enhancement circuit 83b is provided in place of the boost circuit 83a (refer to Fig. 3) in the first embodiment and the other circuits are similar to those in the first embodiment.

The boost/enhancement circuit 83b amplifies the burst signal supplied from the gate circuit 84 to a magnitude of the micro-reciprocal motion amplitude Mf based on the designation from the controller 25. The boost/enhancement circuit 83b further emphasizes a start edge portion and an end edge portion of the amplified burst-shaped micro-reciprocal motion signal on the basis of the discrimination signal of the pulse width supplied from the pulse width detecting circuit 82 and an enhancement (emphasis) instruction from the controller 25. The enhanced signal is supplied as a micro-reciprocal motion deflection signal F(t) to the deflection signal synthesizing circuit 86. The deflection signal synthesizing circuit 86 superimposes the micro-reciprocal motion deflection signal F(t) to the deflection signal of the X axis, to generate the deflection signal X(t).

As a method of the enhancement process by the boost/enhancement circuit 83b, for example, there are various methods such that a waveform which diminishes following an exponential function from a summit value of an edge portion or an amplitude of only a predetermined time width portion from the edge portion is enhanced, and the like. It is necessary that a value of an enhancement amount has been preset into the deflecting condition table for the micro-reciprocal motion together with the values of the period and amplitude of the micro-reciprocal motion (refer to Fig. 7). Since the determination of those values depends on the characteristics of the electron beam and the characteristics of the resist layer of the master disc, it is necessary that the optimum conditions have previously been decided by experiments. The enhancement process of the edge portion of the micro-reciprocal motion waveform in the pit edge portion can be also executed only to the start edge portion or the end edge portion of the burst waveform.

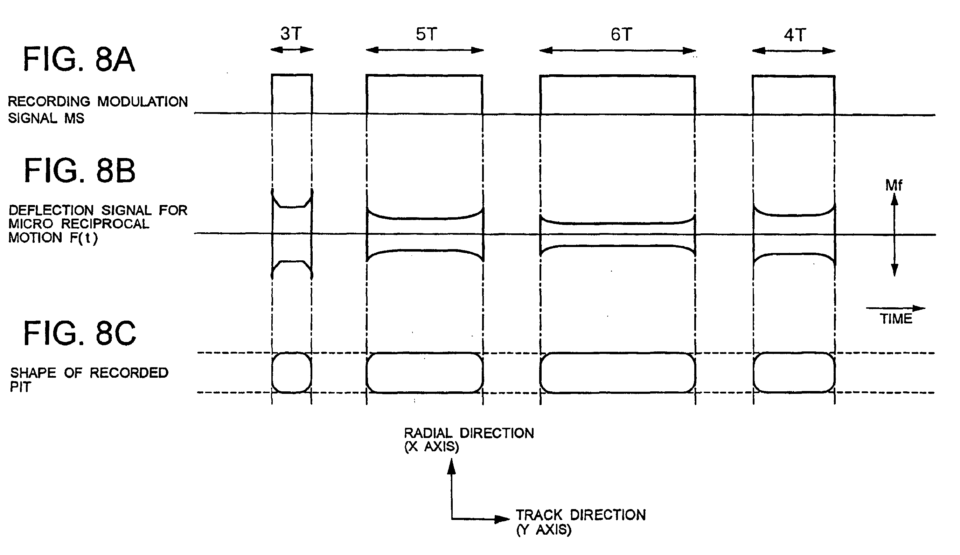

Figs. 8A to 8C show shapes of recording pits which are obtained in correspondence to the recording modulation signal and the micro-reciprocal motion deflection signal in the second embodiment. In a manner similar to the case of Fig. 4, the recording modulation signal MS is shown as an example of a pulse train whose pulse widths are equal to 3T, 4T, 5T, and 6T. The micro-reciprocal motion deflection signal F(t) which is generated in accordance with it has a burst length matched with the pulse width of the recording modulation signal MS. When considering the amplitude of the micro-reciprocal motion deflection signal F(t), the pit whose desired pit length is short is set to be larger than that in the case of the pit whose desired pit length is long in a manner similar to the case of the first embodiment. Further, as for the amplitude of the micro-reciprocal motion deflection signal F(t), a waveform whose amplitudes in the start edge portion and the end edge portion are enhanced is provided. In the diagram, as for the waveform of the micro-reciprocal motion deflection signal, it is expressed with respect to a portion of its envelope and a micro reciprocal portion is omitted for the purpose of making an explanation easy. The shape of pit which is obtained as a result of the enhancement process is formed so that the curvature R in a corner portion is further smaller than that in the case of the first embodiment. An area efficiency of one pit is further raised, thereby improving the recording density. Since it is expected that the pit shape is fixed to a predetermined shape and stable, it is also expected that the jitter of the reproduction signal is improved.

The information recording medium according to the invention can be manufactured by the electron beam recorder in the embodiment. The manufacturing step comprises an information recording step, a developing step, and a transfer step. In the information recording step, while the master disc on which the resist layer has been formed is supported to rotate, irradiation of the electron beam which is intensity modulated in accordance with data which should form recording pits is performed in the rotating track forming direction. In this process, a micro-reciprocal motion of the electron beam is produced in a direction crossing the track forming direction when the irradiation is taking place. At the same time, the amplitude of the micro-reciprocal motion of the electron beam is adjusted in accordance with the pit length of the recording pit. A latent image of a predetermined recording pit train is, thus, formed on the master disc.

In the developing step, the latent image of the predetermined recording pit train is formed on the resist layer by the information recording step is developed and the predetermined recording pit train is formed on the resist layer. In the transfer step, a stamper on which the predetermined recording pit train has been formed by transferring the predetermined recording pit train formed on the resist layer by the developing step is manufactured. For example, a synthetic resin or the like is hot-press worked or injection molded by using the manufactured stamper, further, the recording surface onto which the concave/convex patterns have been transferred from the master disc is subjected to a metal evaporation depositing process, and a translucent substrate or the like is formed, so that an information recording medium such as a DVD is manufactured.

Although the invention has been described by way of the above example in which the resist layer is exposed to the electron beam, the invention can be also applied to the case of exposing the resist layer to a laser beam by which a beam spot of a small diameter like that of the electron beam is obtained.

By the information recording method according to the first aspect of the invention as described above, the information recording method for manufacturing the master disc which can precisely form the pits of optimum shapes is provided. By the information recording apparatus and the recording medium according to the invention, the information recording apparatus which can precisely form the pit train of the optimum shapes is provided, so that the information recording medium is provided on which the precise pits have been formed.

The third embodiment of the invention will be described in detail with reference to the drawings.

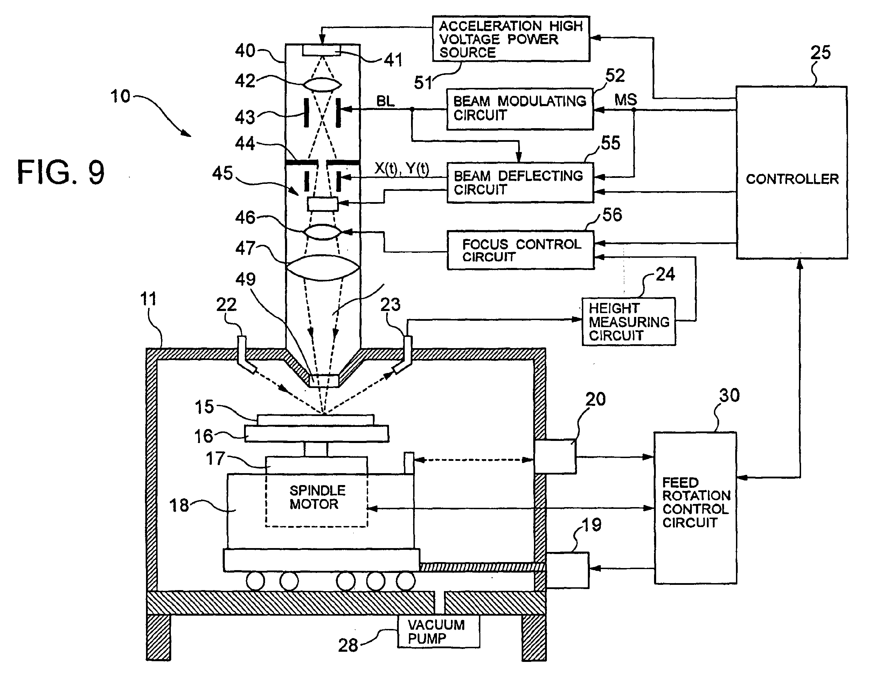

Fig. 9 is a schematic block diagram of the electron beam recorder 10 according to the third embodiment of the information recording apparatus of the invention. As shown in the diagram, the electron beam recorder 10 has almost the same construction as that of the electron beam recorder 10 shown in Fig. 2.

In the diagram, the focus control circuit 56 drives the focus adjustment lens 46 on the basis of the height data obtained by the measurement by the height measuring circuit 24 so as to focus the electron beam onto the surface of the resist layer on the master disc 15. By the focus adjustment, the beam spot of the electron beam is formed onto the surface of the resist layer.

The beam deflecting electrode 45 comprises electrodes which are arranged so as to cross perpendicularly and face each other. That is, the beam deflecting electrode 45 is provided in a manner such that the electron beam supplied via the aperture 44 can be independently deflected in two directions, that is, a track direction Y and a disc radial direction X on the surface of the master disc 15. The biaxial electrodes of the beam deflecting electrode 45 are controlled by the disc radial direction deflection signal X(t) and the track direction deflection signal Y(t) generated from the beam deflecting circuit 55 respectively and deflect the electron beam in the axial directions, respectively. The beam deflecting circuit 55 forms the track direction deflection signal Y(t) in the track direction based on a blanking signal BL supplied from the beam modulating circuit 52, which will be explained later. The beam deflecting circuit 55 further forms the disc radial direction deflection signal X(t) for moving the beam spot in the disc radial direction one track pitch by one every rotation of the master disc 15. The beam deflecting electrode 45, consequently, deflects the electron beam in the disc radial direction in accordance with the disc radial direction deflection signal X(t). The beam deflecting electrode 45 further deflects the electron beam in the track direction Y by a distance corresponding to the track direction deflection signal Y(t).

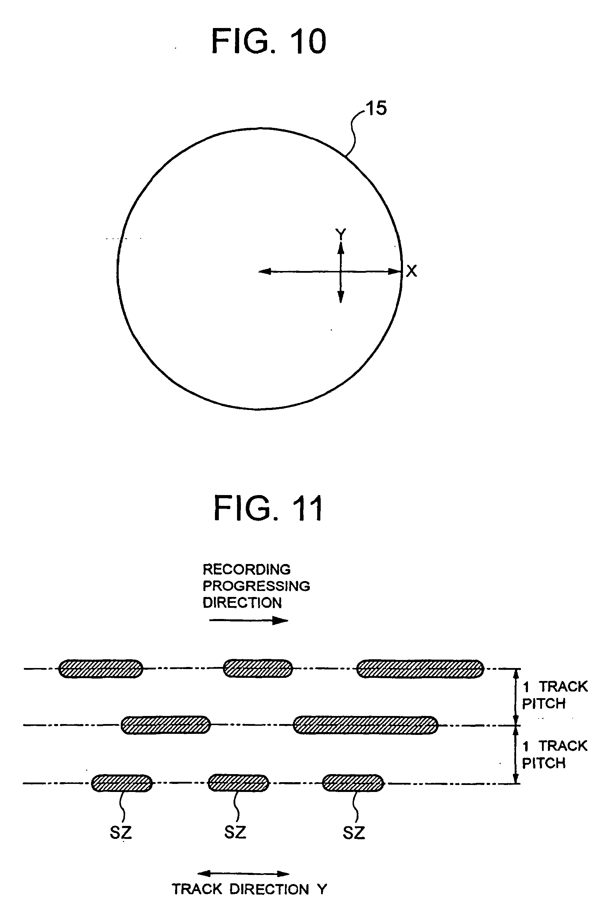

The blanking electrode 43 deflects a beam axis of the electron beam in accordance with the blanking signal BL supplied from the beam modulating circuit 52. A case where the electron beam passes through the aperture 44 and is guided to the beam deflecting electrode 45, focus adjustment lens 46, and objective lens 47 (hereinafter, this case is referred to as a beam ON state) and a case where the passage of the electron beam is blocked at the aperture 44 (hereinafter, this case is referred to as a beam OFF state) are consequently caused. At this time, the beam modulating circuit 52 generates the blanking signal BL in accordance with the recording modulation signal MS supplied from the controller 25. The recording modulation signal MS is a signal obtained by performing a predetermined recording modulating process to the information data to be recorded onto the optical disc. The electron beam, thus, enters alternately the beam ON state or the beam OFF state in accordance with the information data to be recorded onto the optical disc. The electron beam is irradiated onto the surface of the resist layer on the master disc 15 only for a period of time during the beam ON state. On the surface of the resist layer on the master disc 15 which is rotated by the spindle moor 17, thus, a series of latent images SZ corresponding to the recording pits are spirally formed only in the portions to which the electron beam has been irradiated as shown in Fig. 11.

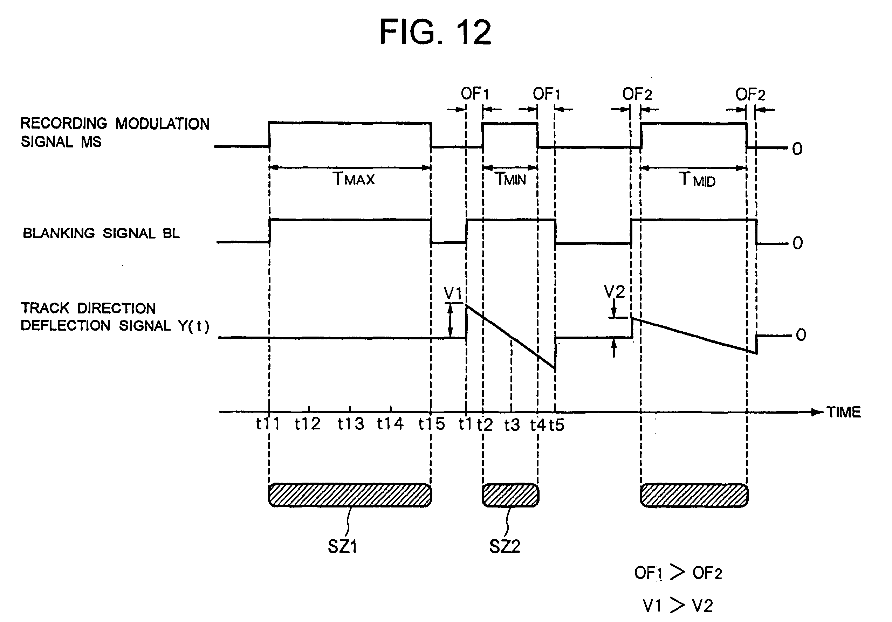

When the electron beam is irradiated onto the surface of the resist layer on the master disc 15 as mentioned above, electron beam deflection control as shown in Fig. 12 is executed in the electron beam recorder 10 according to the invention.

First, if a period of time of the logic level 1 in the recording modulation signal MS, that is, a period of time corresponding to the pit length of the recording pit to be recorded onto the optical disc is relatively long, the beam modulating circuit 52 generates the blanking signal BL which maintains the logic level 1 only for the same period of time as that period. If the period of time of the logic level 1 in the recording modulation signal MS is short, the beam modulating circuit 52 generates a signal in which the above period is extended forward and backward by a predetermined period as a blanking signal BL. For example, as shown in Fig. 12, during a period of time when the recording modulation signal MS of a pulse width T_{MAX} in which the period of time of the logic level 1 becomes maximum is supplied, the beam modulating circuit 52 generates the blanking signal BL which maintains the logic level 1 only for the same period of time as the pulse width T_{MAX}. When the recording modulation signal MS of a pulse width T_{MIN} in which the period of time of the logic level 1 becomes minimum is supplied, the beam modulating circuit 52 generates the following blanking signal BL as follows. That is, as shown in Fig. 12, the beam modulating circuit 52 makes front edge timing of the recording modulation signal MS of the pulse width T_{MIN} earlier by a predetermined offset period OF₁ and delays rear edge timing by the offset period OF₁, thereby generating the blanking signal BL in which the period of time of the logic level 1 is extended. If the recording modulation signal MS of the pulse width T_{MID} larger than the pulse width T_{MIN} and smaller than the pulse width T_{MAX} is supplied, the beam modulating circuit 52 generates the following blanking signal BL. That is, as shown in Fig. 12, the beam modulating circuit 52 makes the front edge timing of the recording modulation signal MS of the pulse width T_{MID} earlier by a predetermined offset period OF₂ (OF₁ > OF₂) and delays rear edge timing by the offset period OF₂, thereby generating the blanking signal BL in which the period of time of the logic level 1 is extended.

At this time, only during the period of time when the blanking signal BL is at the logic level 1, the blanking electrode 43 deflects the electron beam supplied from the convergent lens 42 so as to pass through the aperture 44. That is, during the period of time, the electron beam enters the beam ON state and is irradiated onto the surface of the resist layer on the master disc 15. That is, the period of time when the blanking signal BL is at the logic level 1 becomes an irradiating period of time during which the electron beam is irradiated to the resist layer on the master disc 15.

Only during the period of time when the blanking signal BL is at the logic level 1, the beam deflecting circuit 55 generates the track direction deflection signal Y(t) whose level is gradually shifted from a positive voltage to a negative voltage (or from the negative voltage to the positive voltage). In this instance, when the recording modulation signal MS in which a period of time of the logic level 1 is long is supplied, the beam deflecting circuit 55 generates the track direction deflection signal Y(t) whose voltage transition width, that is, amplitude is small. When the recording modulation signal MS in which a period of time of the logic level 1 is short is supplied, the beam deflecting circuit 55 generates the track direction deflection signal Y(t) whose amplitude is large. That is, the beam deflecting circuit 55 generates the track direction deflection signal Y(t) whose amplitude is larger as the period of time of the logic level 1 is shorter in the recording modulation signal MS and whose level is gradually shifted from the positive voltage to the negative voltage (or from the negative voltage to the positive voltage). For example, in Fig. 12, during the period of time when the recording modulation signal MS of the pulse width T_{MAX} in which the period of time of the logic level 1 becomes maximum is supplied, the beam deflecting circuit 55 generates the track direction deflection signal Y(t) of the amplitude "0", that is, at the constant 0 level. As shown in Fig. 12, when the recording modulation signal MS of the pulse width T_{MIN} in which the period of time of the logic level 1 becomes minimum is supplied, the beam deflecting circuit 55 generates the track direction deflection signal Y(t) whose voltage is shifted from a positive voltage V1 to a negative voltage (-V1) during the period of time when the blanking signal BL is at the logic level 1. When the recording modulation signal MS of the pulse width T_{MID} which is larger than the pulse width T_{MIN} and smaller than the pulse width T_{MAX} is supplied, the beam deflecting circuit 55 generates the track direction deflection signal Y(t) whose voltage is shifted from a positive voltage V2 to a negative voltage (-V2) during the period of time when the blanking signal BL is at the logic level 1. The voltage V1 is higher than the voltage V2.

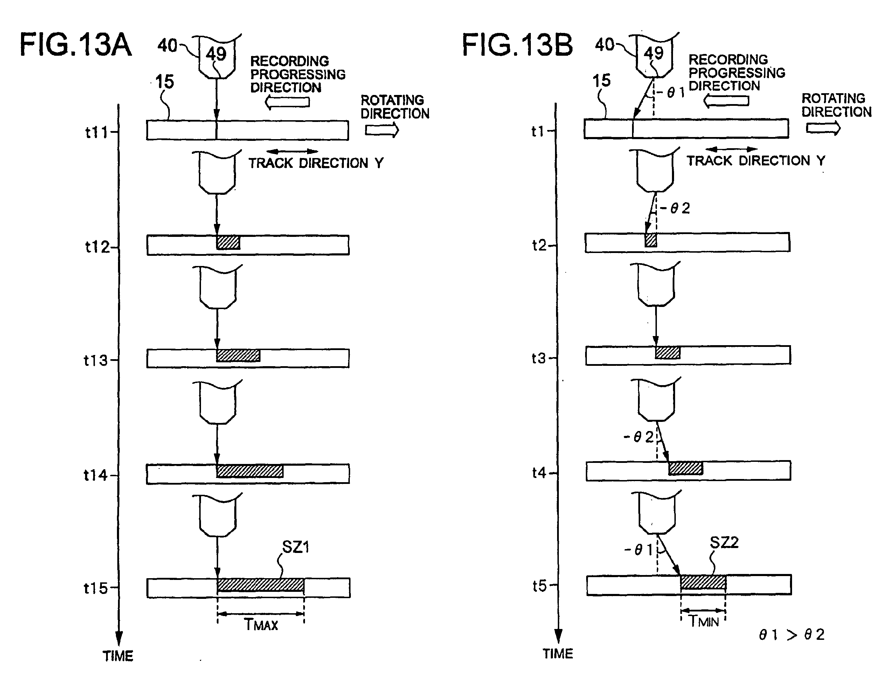

According to the electron beam deflection control as mentioned above, for example, when the recording modulation signal MS of the pulse width T_{MAX} in which the period of time of the logic level 1 becomes maximum is supplied as shown in Fig. 12, the electron beam is irradiated onto the surface of the resist layer on the master disc 15 during this period of time (time point t11 to time point t15). Since the signal level of the track direction deflection signal Y(t) is equal to "0" for this period of time as shown in Fig. 12, the electron beam is irradiated perpendicularly to the surface of the master disc 15 from the electron beam emitting port 49 of the electron beam column portion 40 during this period of time (time point t11 to time point t15) as shown in Fig. 13A. Since the master disc 15 is rotating by the spindle motor 17 for this period of time (time point t11 to time point t15), the position of the beam spot which is formed on the resist layer on the master disc 15 is moved in the direction opposite to the rotating direction of the spindle motor 17, that is, in the recording progressing direction. As shown by hatched regions in Figs. 12 and 13A, therefore, a latent image SZ1 having the same length as the pulse width T_{MAX} is formed on the resist layer on the master disc 15.

When the recording modulation signal MS of the pulse width T_{MIN} in which the period of time of the logic level 1 becomes minimum is supplied as shown in Fig. 12, the electron beam is irradiated onto the surface of the resist layer on the master disc 15 during this period of time (time point t1 to time point t5) including the above minimum period and the offset periods OF₁ before and after it. The signal level of the track direction deflection signal Y(t) is gradually shifted from the positive voltage V1 to the negative voltage (-V1) for the period of time (time point t1 to time point t5) as shown in Fig. 12. For example, as shown in Fig. 12, the signal level of the track direction deflection signal Y(t) is set to the positive voltage V1 at time point t1, a positive voltage (V1/2) at time point t2, a voltage "0" at time point t3, a negative voltage (-V1/2) at time point t4, and a negative voltage (-V1) at time point t5, respectively. In this instance, the beam deflecting electrode 45 deflects the electron beam in the track direction Y by an angle corresponding to the signal level of the track direction deflection signal Y(t). At time point t1, therefore,: the electron beam deflected in the track direction Y by an angle θ1 corresponding to the positive voltage V1 is irradiated to the surface of the resist layer on the master disc 15 from the electron beam emitting port 49 of the electron beam column portion 40. That is, at time point t1, as shown in Fig. 13B, the electron beam deflected in the recording progressing direction in the direction Y along the track by the angle θ1 is irradiated to the surface of the resist layer on the master disc 15. At time point t2, the electron beam deflected in the track direction Y by an angle θ2 corresponding to the positive voltage (V1/2) is irradiated to the surface of the resist layer on the master disc 15 from the electron beam emitting port 49 of the electron beam column portion 40. That is, at time point t2, as. shown in Fig. 13B, the electron beam deflected in the recording progressing direction in the direction Y along the track by the angle θ2 is irradiated to the surface of the resist layer on the master disc 15. The angle θ2 is smaller than the angle θ1. At time point t3, as shown in Fig. 13B, the electron beam is irradiated to the surface of the resist layer at the angle corresponding to the voltage "0", that is, perpendicularly to the surface of the resist layer. At time point t4, the electron beam deflected in the track direction Y by an angle (-θ2) corresponding to the negative voltage (-V1/2) is irradiated to the surface of the resist layer on the master disc 15 from the electron beam emitting port 49 of the electron beam column portion 40. That is, at time point t4, as shown in Fig. 13B, the electron beam deflected in the direction opposite to the recording progressing direction in the direction Y along the track by the angle θ2 is irradiated to the surface of the resist layer on the master disc 15. At time point t5, the electron beam deflected in the track direction Y by an angle (-θ1) corresponding to the negative voltage (-V1/2) is irradiated to the surface of the resist layer on the master disc 15 from the electron beam emitting port 49 of the electron beam column portion 40. That is, at time point t5, as shown in Fig. 13B, the electron beam deflected in the direction opposite to the recording progressing direction in the direction Y along the track by the angle θ1 is irradiated to the surface of the resist layer on the master disc 15.

During the period of time (time point t1 to time point t5), the position of the beam spot which is formed on the resist layer on the master disc 15 is moved in the direction opposite to the rotating direction of the spindle motor 17, that is, in the recording progressing direction. For the period of time (time point t1 to time point t5), therefore, the electron beam is irradiated into an area of the same length as the pulse width T_{MIN} and a latent image SZ2 having the same length as the pulse width T_{MIN} is formed on the resist layer on the master disc 15.

At this time, according to the deflection control of the electron beam as shown in Fig. 13B, in the irradiating period of time of the electron beam, first, the electron beam is deflected in the recording progressing direction along the track, a deflection amount is gradually reduced, and the electron beam is gradually deflected in the direction opposite to the recording progressing direction. Since a relative moving speed at the time when the electron beam spot traces the surface of the resist layer decreases, therefore, an exposing time of the electron beam per unit area increases more than that in the case of Fig. 13A. According to the deflection control of the electron beam, consequently, a width of latent image corresponding to the recording pit of the short pit length can be equalized to a width of latent image corresponding to the recording pit of the long pit length.

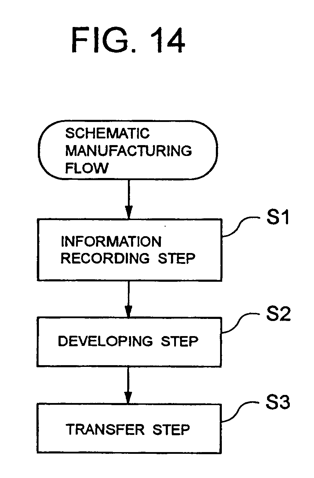

Fig. 14 is a diagram showing a schematic manufacturing flow which is executed until the stamper is manufactured after the latent image was formed onto the resist layer by the electron beam exposure as mentioned above.

First, in an information recording step S1, a latent image is formed onto the resist layer on the master disc 15 by the electron beam exposure as mentioned above. That is, in the information recording step S1, while the master disc 15 on which the resist layer has been formed is rotated, the electron beam is irradiated onto the surface of the resist layer in accordance with the recording modulation signal MS. At this time, as shown in Figs. 12, 13A, and 13B, while the electron beam is deflected in the direction along the track by the deflection amount according to the pulse width of the recording modulation signal MS, it is irradiated onto the resist layer. A latent image corresponding to the recording pit train is, thus, formed onto the resist layer.

In a next developing step S2, the latent image formed on the resist layer is developed. A recording mark of the same form as that of the latent image is, thus, formed in the position of the latent image.

In a next transfer step S3, by transferring the resist layer on which the recording mark has been formed by the developing step S2, a stamper on which the recording pits have been formed is manufactured.

The recording pit having a uniform pit width and a good form is, therefore, formed on an optical disc duplicated by using the stamper irrespective of the pit length.

In the embodiment, the beam deflecting circuit 55 generates the track direction deflection signal Y(t) of the waveform shown in Fig. 12 in accordance with the recording modulation signal MS and the blanking signal BL. Its waveform shape, however, is not limited to that shown in Fig. 12.

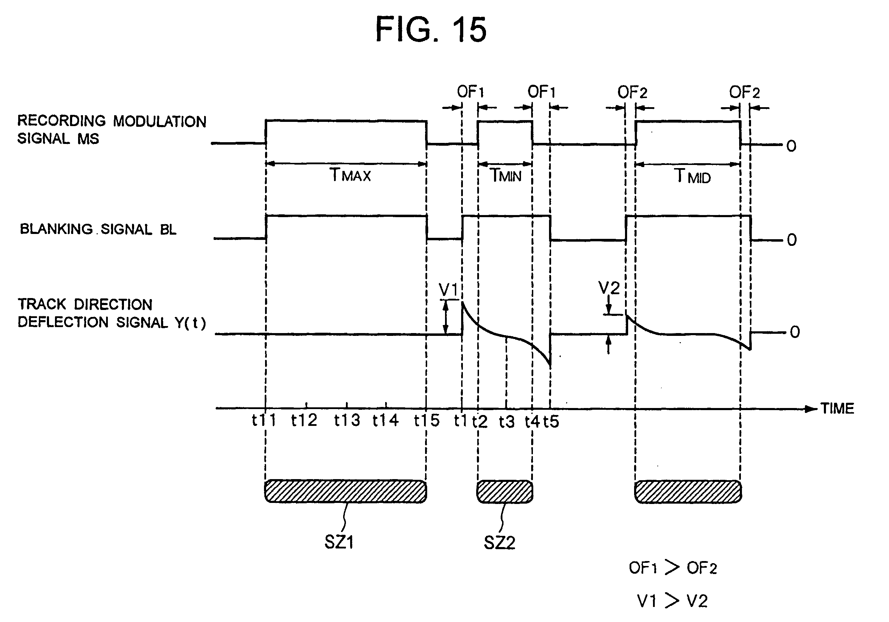

For example, the beam deflecting circuit 55 generates the track direction deflection signal Y(t) of the waveform as shown in Fig. 15 in accordance with the recording modulation signal MS and the blanking signal BL and supplies it to the beam deflecting electrode 45. In the track direction deflection signal Y(t), a level transition in each of a trailing edge start portion DS and a leading edge start portion US is set to be steep. The irradiating time of the electron beam to an edge portion EG of the latent image SZ is, thus, longer than that in the case of using the track direction deflection signal Y(t) shown in Fig. 12 and the width of latent image in the edge portion EG can be further increased. The recording pit having a better edge form is, consequently, formed on an optical disc manufactured by using the stamper formed by the electron beam exposure based on the track direction deflection signal Y(t) shown in Fig. 15.

As described above, the according to the invention, optical discs can be duplicated, from which a read signal having a good waveform can be obtained even from the recording pit of short pit lengths.

## Claims

1. An information recording method of irradiating a resist layer formed on a substrate with an electron beam and forming a latent image of a recording pit train along a track, comprising the steps of:
performing an irradiation process with the electron beam driven to cause a micro-reciprocal motion in a direction crossing said track direction while an irradiation position of said electron beam is moved in said track direction; and
adjusting an amplitude of said micro-reciprocal motion in accordance with a pit length of a recording pit to be formed.

2. A method according to claim 1, wherein when the pit length of said recording pit is short, the amplitude of said micro-reciprocal motion is made larger than that in the case where said pit length is long.

3. A method according to claim 1, wherein a period of said micro-reciprocal motion is equal to or less than a shortest pit length among pit lengths of recording pits of said recording pit train.

4. A method according to claim 1, wherein the amplitude of said micro-reciprocal motion in a start edge portion and/or an end edge portion of said recording pit is made larger than that in an intermediate portion of said recording pit.

5. A method according to any one of claims 1 to 4, wherein the size of a spot on a master disc which is obtained by the irradiation with said electron beam is smaller than the size of a corresponding recording pit to be formed onto said master disc.

6. An information recording apparatus which has a rotation driving unit for supporting and rotating a master disc on which a resist layer has been formed, and an electron beam emitting unit for irradiating said master disc with an electron beam so that it can be freely deflected and which forms a latent image of a recording pit train along a track forming direction of said master disc being rotated, comprising:
an emission control unit for supplying an instruction to modulate an intensity of the electron beam in accordance with data to form said recording pits to said electron beam emitting unit; and
a deflection control unit for supplying an instruction to cause, in an irradiation process, a micro reciprocal motion of the intensity-modulated electron beam in a direction which crosses said track forming direction and to adjust an amplitude of the micro-reciprocal motion of said electron beam in accordance with a pit length of a recording pit to be formed to said electron beam emitting unit.

7. An apparatus according to claim 6, wherein when the pit length of said recording pit is short, the amplitude of said micro-reciprocal motion is made larger than that in the case where said pit length is long.

8. An apparatus according to claim 6, wherein a period of said micro-reciprocal motion is equal to or less than a shortest pit length among recording pits of said recording pit train.

9. An apparatus according to claim 6, wherein in a start edge portion and/or an end edge portion of said recording pit, the amplitude of said micro-reciprocal motion is set to be larger than that in an intermediate portion of said recording pit.

10. An apparatus according to any one of claims 6 to 9, wherein a size of spot on said master disc which is obtained by the irradiation with said electron beam is smaller than a size of recording pit to be formed onto said master disc.

11. An information recording medium including a substrate duplicated by using a master disc in which a recording pit train has been formed on a resist layer, wherein said recording medium is obtained by being duplicated by executing:
an information recording step of performing an irradiation process by an electron beam which has been intensity-modulated in accordance with data to form said recording pit, said electron beam being driven to cause a micro-reciprocal movement in a direction which crosses the track forming direction of rotation of the master disc while supporting and rotating said master disc on which said resist layer has been formed, adjusting an amplitude of said micro-reciprocal motion in accordance with a pit length of a recording pit to be formed, and forming a latent image of said recording pit train;
a developing step of developing the latent image of said recording pit train formed by said information recording step and forming the developed recording pit train developed into said resist layer; and
a transfer step of manufacturing a stamper on which said recording pit train is formed by transferring the recording pit train formed and developed by said developing step.

12. An information recording method of irradiating a resist layer formed on a substrate with an exposing beam in accordance with a pulse signal corresponding to a recording pit train, thereby recording a latent image corresponding to said recording pit along a track onto said resist layer, comprising:
an irradiating period adjusting step of adjusting an irradiating period of time of said exposing beam in accordance with a pulse width of said pulse signal; and
a deflecting step of deflecting said exposing beam in a direction along said track in response to said pulse signal.

13. A method according to claim 12, wherein said irradiating period adjusting step includes a step of setting a period of time obtained by adding an offset period which is longer as said pulse width is shorter to said pulse width to said irradiating period of time of said exposing beam.

14. A method according to claim 12, wherein said deflecting step includes a step of, when the pulse width of said pulse signal is short, deflecting said exposing beam in the direction along said track within said irradiating period, thereby reducing a relative moving speed between a beam spot formed on a surface of said resist layer by said exposing beam and said resist layer.

15. A method according to claim 12, wherein said deflecting step includes a step of deflecting said exposing beam in a direction in which the recording is progressing in the direction along said track within said irradiating period of time, thereafter, gradually reducing a deflection amount, and gradually deflecting said exposing beam in the direction opposite to said direction in which the recording progressing.

16. A method according to claim 12 or 15, wherein said deflecting step includes a step of adjusting the deflection amount of said exposing beam in accordance with the pulse width of said pulse signal.

17. A method according to claim 12, wherein said deflecting step includes a step of deflecting said exposing beam in the direction along said track, thereby reducing a relative moving speed between a beam spot formed on a surface of said resist layer by said exposing beam and the surface of said resist layer at an irradiation start time and/or an irradiation end time with said exposing beam to a speed lower than that at an intermediate time point between said irradiation start time and said irradiation end time.

18. An information recording apparatus for irradiating an exposing beam onto a surface of a resist layer formed on a master disc, thereby forming a latent image corresponding to a recording pit onto said resist layer along a track, comprising:
a rotation driving unit for rotating said master disc;
an exposing beam emitting unit for irradiating the surface of said resist layer with said exposing beam for a period of time obtained by adding an offset period which is longer as a pulse width of a pulse signal corresponding to said recording pit train is shorter to said pulse width; and
a beam deflecting unit for deflecting said exposing beam in a direction along said track by a deflection amount according to the pulse width of said pulse signal.

19. A recording medium having a substrate duplicated based on master disc on which a predetermined recording pit train has been formed along a track and a recording layer formed on said substrate, wherein duplication of said medium is performed by executing:
an information recording step of rotating said master disc on which a resist layer has been formed and irradiating said resist layer with an exposing beam while deflecting said exposing beam in a direction along said track by a deflection amount according to a pulse width of a pulse signal corresponding to said recording pit train, thereby forming a latent image corresponding to said recording pit train onto said resist layer;
a developing step of developing said latent image formed on said resist layer and forming a recording mark onto said resist layer; and
a transfer step of transferring said resist layer on which said recording mark has been formed, thereby producing a stamper on which said predetermined recording pit train has been formed.
